# EUROPEAN PATENT APPLICATION

(11) **EP 4 333 042 A2**
(43) Date of publication of application: **06.03.2024**
(21) Application number: 23186269.9
(22) Date of filing: 19.07.2023
(51) Int. Cl.: H01L 21/8252, H01L 27/06, H01L 27/085, H01L 29/10, H01L 29/20, H01L 29/40, H01L 29/778

(54) **HIGH-ELECTRON-MOBILITY TRANSISTOR**

(30) Priority: 02.09.2022 US 202217902463
(71) Applicant: GlobalFoundries U.S. Inc., Malta, NY 12020 (US)
(72) Inventor: SHARMA, Santosh, Austin, TX, 78735 (US); BENTLEY, Steven, Malta, NY, 12020 (US)
(74) Representative: Lambacher, Michael

(57) **Abstract**

The present disclosure relates to semiconductor structures and, more particularly, to a high-electron-mobility transistor and methods of manufacture. The structure includes: at least one depletion mode gate (21) on a conductive material over a semiconductor material (14); and at least one enhancement mode gate (19) electrically connected to the at least one depletion mode gate and over the semiconductor material.

## Description

### BACKGROUND

The present disclosure relates to semiconductor structures and, more particularly, to a high-electron-mobility transistor and methods of manufacture.

A high-electron-mobility transistor (HEMT) is a field-effect transistor incorporating a junction between two materials with different band gaps (i.e. a heterojunction) as the channel, instead of a doped region (as is generally the case for a MOSFET). Commonly used material combinations are GaN or GaAs, although other materials can be used dependent on the application of the device.

HEMT transistors are able to operate at higher frequencies than ordinary transistors, up to millimeter wave frequencies. As the HEMT transistors are able to operate at higher frequencies, they can be used in high-frequency products such as cell phones, satellite television receivers, voltage converters, and radar equipment. For example, a HEMT may be used in satellite receivers and in low power amplifiers.

Depletion mode pinch off voltages in enhancement mode flows are typically higher than -6V; however, a layout programmable depletion mode pinch off of less than -6V is needed for GaN integrated circuit development, e.g., for building a low voltage reference, etc. Hence control of Vpinch becomes critical.

### SUMMARY

In an aspect of the disclosure, a structure comprises: at least one depletion mode gate on a conductive material over a semiconductor material; and at least one enhancement mode gate electrically connected to the at least one depletion mode gate.

Additional features of the structure are set forth in dependent claims 2 to 10. In an aspect of the disclosure, a structure comprises: a metal-insulator-semiconductor (MIS) capacitor, the MIS capacitor comprising a metal plate over a common conducting channel; and an island of semiconductor material over a semiconductor substrate and electrically connected to the MIS capacitor.

Additional features of the structure are set forth in dependent claims 12 to 14. In an aspect of the disclosure, a method comprises: forming at least one depletion mode gate comprising a field plate on a conductive material over a semiconductor material; and forming at least one enhancement mode gate electrically connected to the at least one depletion mode gate.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1 shows a HEMT with an enhancement mode gate and a depletion mode gate and respective fabrication processes in accordance with aspects of the present disclosure.
FIG. 2 shows a HEMT with an enhancement mode gate and a depletion mode gate in accordance with additional aspects of the present disclosure.
FIG. 3 shows the enhancement mode gate electrically connected to the depletion mode gate in accordance with aspects of the present disclosure.
FIGS. 4, 5, 6A and 6B show several layouts of different HEMTs in accordance with aspects of the present disclosure.
FIG. 7A shows a HEMT with an enhancement mode gate and a depletion mode gate in accordance with additional aspects of the present disclosure.
FIG. 7B shows a cross-sectional view of the device of FIG. 7A, along lines A-A.
FIGS. 8A-8D show fabrication processes for manufacturing the structure shown in FIG. 1 in accordance with aspects of the present disclosure.

### DETAILED DESCRIPTION

The present disclosure relates to semiconductor structures and, more particularly, to a high-electron-mobility transistor and methods of manufacture. More specifically, the present disclosure provides structures for depletion mode GaN HEMT Vt control. Advantageously, the present disclosure provides a dedicated depletion mode gate which provides significant improvement in gate control and subthreshold behavior. Also, no additional process complexity is required to generate multiple threshold depletion modes (d-modes).

More specifically, the high-electron-mobility transistor (HEMT) may be a GaN HEMT with two gates, e.g., depletion mode gate and enhancement mode gate, connected together and, in embodiments, an isolation region (e.g., implant or shallow trench isolation structure)) placed between the two gates. The first gate metal (depletion mode gate) may be set for depletion mode operation and the second gate metal (enhancement mode gate) may be set for enhancement mode operation. In embodiments, the enhancement mode gate and the depletion mode gate may utilize field plates that are formed in a same deposition and patterning process. The depletion mode gate forms part of a metal-insulator-semiconductor (MIS) capacitor and the enhancement mode gate may be composed of an epitaxially grown p-type doped GaN layer. In embodiments, islands of the pGaN (enhancement mode gates) may be connected to MIS regions (depletion mode gate) by a common gate conductor. In alternative embodiments, the enhancement mode gate and the MIS region may be separately connected.

The HEMTs of the present disclosure can be manufactured in a number of ways using a number of different tools. In general, though, the methodologies and tools are used to form structures with dimensions in the micrometer and nanometer scale. The methodologies, i.e., technologies, employed to manufacture the HEMTs of the present disclosure have been adopted from integrated circuit (IC) technology. For example, the structures are built on wafers and are realized in films of material patterned by photolithographic processes on the top of a wafer. In particular, the fabrication of the HEMTs uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

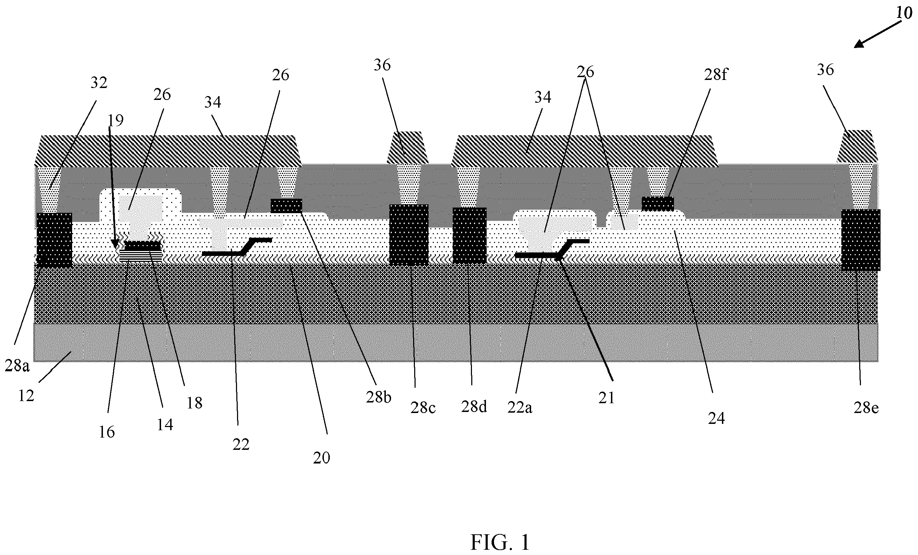

FIG. 1 shows a HEMT with an enhancement mode gate and a depletion mode gate, and respective fabrication processes in accordance with aspects of the present disclosure. As in each of the embodiments, the enhancement mode gate and depletion mode gate may be integrated into a single wafer (substrate) with the depletion mode gate using a same field plate (as the gate) as the field plate for the enhancement mode gate.

More specifically, the structure of FIG. 1 includes a semiconductor substrate 12 with a semiconductor material 14 on the semiconductor substrate 12. The semiconductor material 14 may be AlGaN/GaN, which acts as a conducting channel for the HEMT device, e.g., enhancement mode gate (e-mode gate) and the depletion mode gate (d-mode gate). The semiconductor substrate 12 may be composed of any suitable material including, but not limited to, Si, SiGe, SiGeC, SiC, GaAs, InAs, InP, and other III/V or II/VI compound semiconductors. In preferred embodiments, the semiconductor substrate 12 comprises p-type Si material with a suitable crystal orientation, e.g., (111).

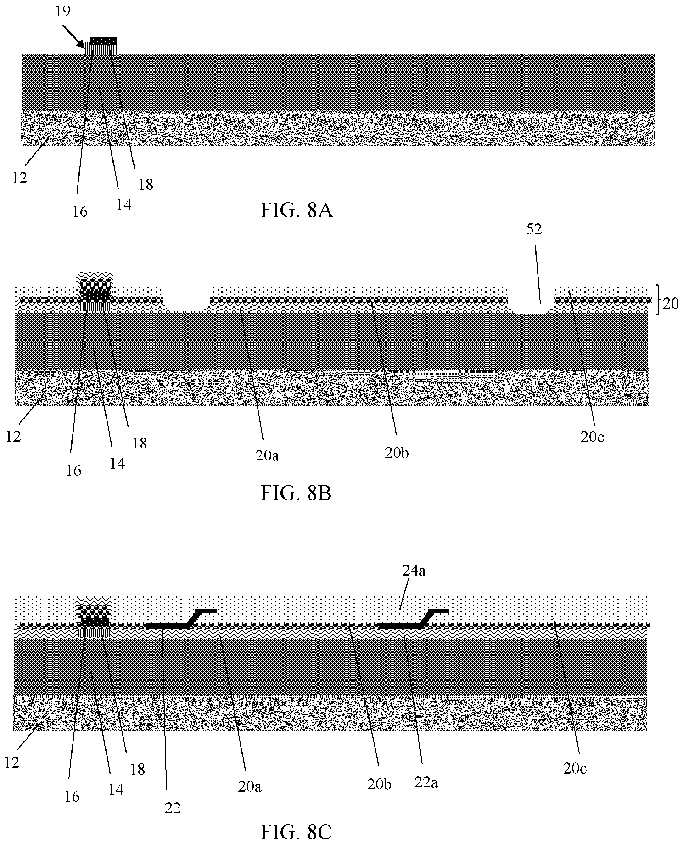

A semiconductor material 16 and conductive material 18 may be formed, e.g., deposited and patterned, on the semiconductor material 14. In embodiments, the semiconductor material 16 comprises, e.g., p-doped GaN, and the conductive material 18 may be, e.g., TiN. The combination of the semiconductor material 16 and the conductive material 18 may be used as an e-mode gate 19. The materials 16, 18 may be deposited by a conventional deposition method (e.g., chemical vapor deposition (CVD)), followed by conventional lithography and etching processes. In further embodiments, the conductive material 18 may be pulled back slightly as described in FIG. 8A.

Still referring to FIG. 1, a plurality of different materials 20 may be formed over the e-mode gate 19 and semiconductor material 14. As described in FIG. 8B, the plurality of different materials 20 may comprise, in sequential order, a conductive layer, e.g., Al₂O₃, an etch stop layer, e.g., SiN, and an insulator material, e.g., SiO₂. The plurality of different materials 20 may be deposited by conventional deposition methods, e.g., CVD processes, in sequential order to form layers of material over the e-mode gate 19 and semiconductor material 14.

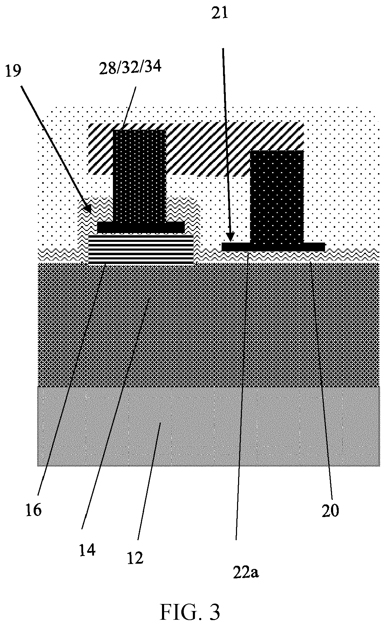

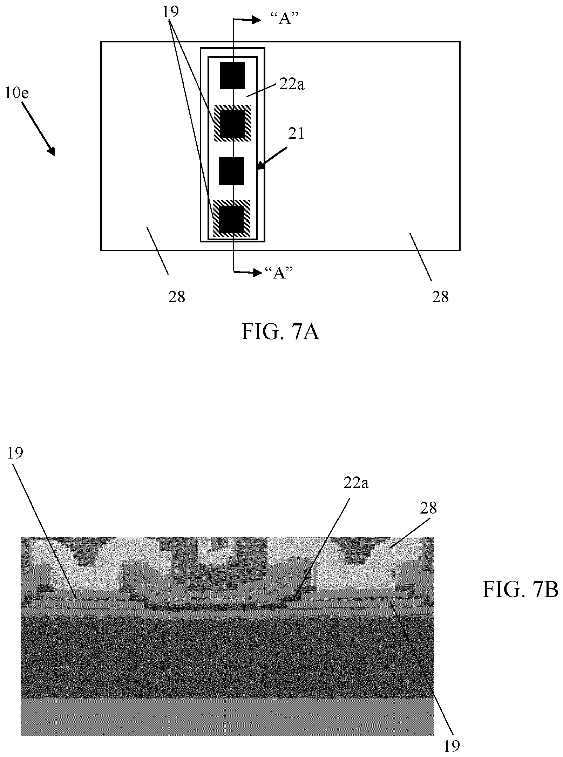

Field plates 22, 22a may be formed partially in contact with the conductive layer, e.g., Al₂O₃, and the insulator material, e.g., SiO₂, of the plurality of different materials 20. In more specific embodiments, the field plates 22, 22a may comprise TiN formed within a trench that exposes the conductive layer, and on a surface of the insulator material as described in FIG. 8C. The field plates 22, 22a may be a common field plate for both the e-mode gate 19 and d-mode gate 21. In embodiments, the field plate 22a may form part of the d-mode gate 21, e.g., a metal-insulator-semiconductor (MIS) capacitor, which is electrically connected to the common conducting channel, e.g., semiconductor material 14, through the conductive material of the plurality of different materials 18. The field plate 22 adjacent to the e-mode gate 19 may also be electrically connected to the common conducting channel, e.g., semiconductor material 14, through the conductive material of the plurality of different materials 18. Moreover, the e-mode gate 19, e.g., pGaN islands, may be electrically connected to the d-mode gate 21 of the MIS gate structure as shown in FIGS. 3 and 7.

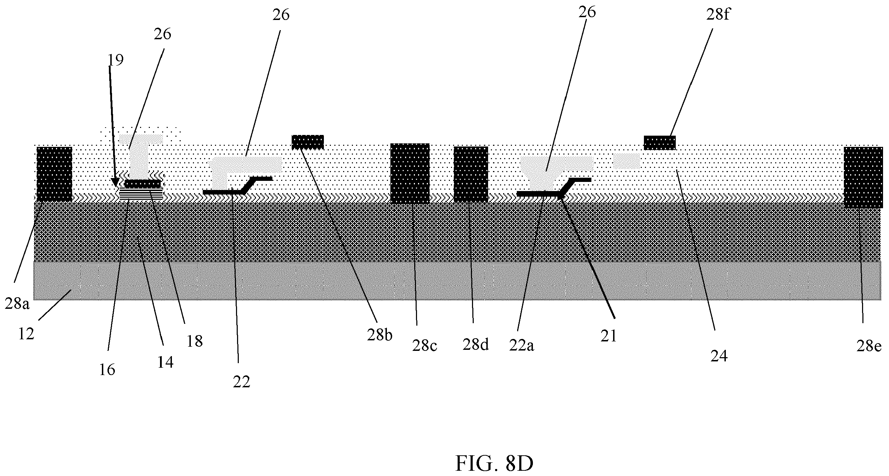

An interlevel dielectric material 24, e.g., layers of oxide and nitride, may be formed over the field plates 22, 22a. A gate contact metal 26 may be formed in contact with the field plates 22, 22a and the conductive material 18, e.g., TiN, of the e-mode gate 19. The gate contact metal 26 may be, e.g., TiAl or TiN. As described in FIG. 8D, the gate contact metal 26 may be formed by patterning of the interlevel dielectric material 24 to expose the underlying field plates 22, 22a and the conductive material 18, e.g., TiN of the e-mode gate 19, followed by deposition of conductive material, e.g., TiN.

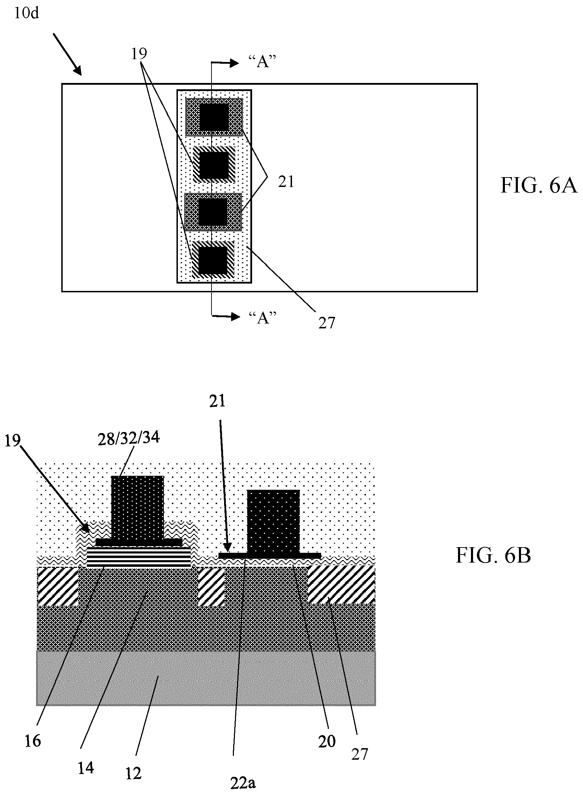

As described in more detail with respect to FIGS. 6A-6B, isolation regions 27 may be formed in the semiconductor material 14. In embodiments, the optional isolation regions 27 may be an argon or nitrogen implant (or other inert or noble gas as is known in the art). More specifically, the optional isolation regions 27 may be self-aligned with the e-mode gate, and may be used to isolate the e-mode gate 19, e.g., pGaN island, (and/or the d-mode gate 21 and/or field plates 22, 22a) in order to modulate and improve pinch off voltage. The pGaN islands 16 may also be used to deplete the 2DEG (e.g., 2-dimensionasl electron gas) in a gap between the gate metal stripes, e.g., gate contact metal 26. In embodiments, the e-mode gate 19, e.g., pGaN 16, and other structures may be shielded from the implant which forms the optional isolation regions 27 by the gate contact metal 26.

Still referring to FIG. 1, ohmic contacts 28a, 28c, 28d, 28e may contact (e.g., electrically connect) to the underlying semiconductor material 14 (e.g., conducting channel); whereas ohmic contacts 28b, 28e may contact the gate contact metal 26 of the e-mode gate 19 and the d-mode gate 21, respectively. An interlevel dielectric material 30 may be formed over the interlevel dielectric material 24. Back end of the line contacts (e.g., metal vias) 32 may connect to the ohmic contacts 28a-28f and the field plates 22, 22a through the gate contact metal 26. In embodiments, the ohmic contacts 28a-28f may be formed using conventional lithography, etching and deposition processes as is known in the art and further described in FIG. 8D. The ohmic contacts 28a-28f may comprise, e.g., TiAl or TiN.

Metal wiring 34, 36 connect to a source region and drain region, respectively, of the e-mode gate 19 and the d-mode gate 21. In embodiments, the metal wiring 34, 36 may electrically connect and be in direct contact with the via contacts 32. The metal wiring 34, 34 to the source region and the drain region may be formed by a back end of the line metal processes (e.g., TiN liner with tungsten fill) as is known in the art.

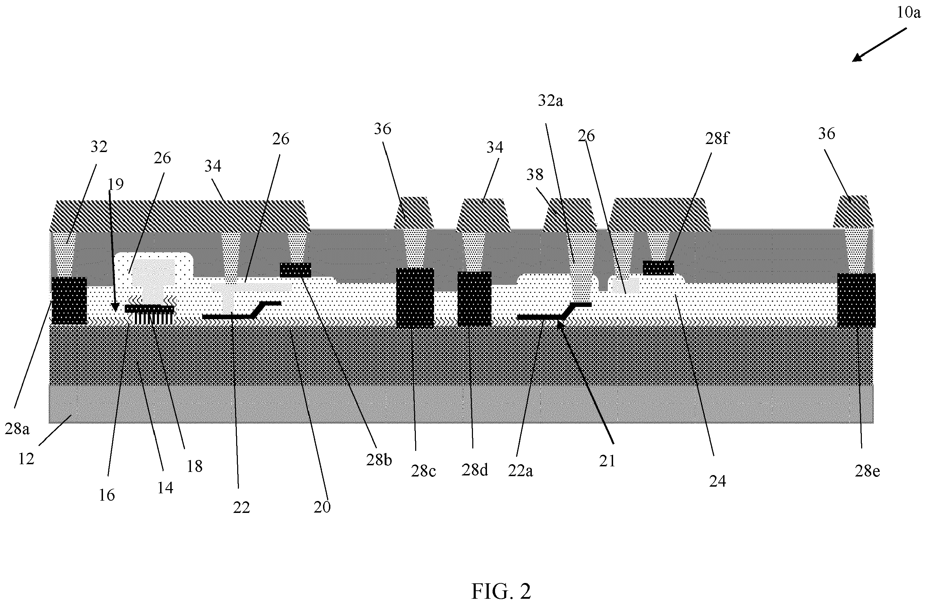

FIG. 2 shows a HEMT with an enhancement mode gate and a depletion mode gate accordance with additional aspects of the present disclosure. In the structure 10a of FIG. 2, the gate contact metal 26 to the field plate 22a may be replaced with a via contact 32a extending directly to the field plate 22a. The via contact 32a may extend through the interlevel dielectric materials 24, 30 and connect to the back end of the line metal wiring 38. In this way, a wiring structure, e.g., gate wiring 38, may be directly connected to the field plate 22a, e.g., d-mode gate 21. The remaining features are similar to the structure 10 of FIG. 1.

FIG. 3 shows the field plate 22a that forms the d-mode gate 21, e.g., a metal-insulator-semiconductor (MIS) capacitor, electrically connected to the e-mode gate 19, e.g., pGaN islands. In embodiments, the field plate 22a may be electrically connected to the e-mode gate 19 by any combination of the metallization features 28, 32, 34 (where metallization feature 28 may be one of the ohmic contacts). In alternative embodiments, the d-mode gate 21 and the e-mode gate 19 may be separately connected.

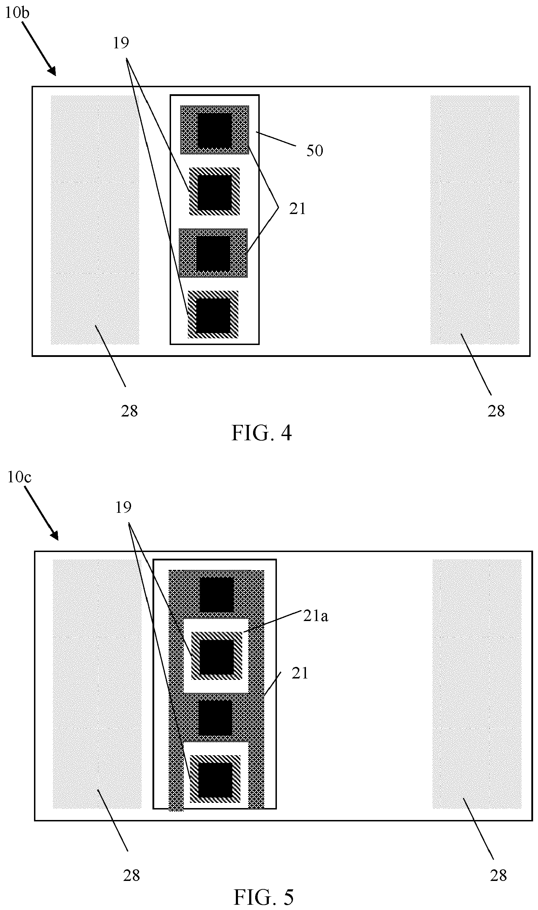

FIGS. 4-6B show different layouts of the d-mode gate and the e-mode gate. For example, in FIG. 4 the structure 10b includes d-mode gates 21 and e-mode gates 19 as separate islands under a single gate finger 50. It should be understood by those of ordinary skill in the art that the d-mode gates 21 and the e-mode gates 19 may be provided under multiple fingers. The spacing and sizing of the d-mode gates 21 and the e-mode gates 19 may be used to adjust the pinch off voltage. For example, the ratios of the pGaN and d-mode gate widths may be adjusted to provide different Vt. In this layout, the pGaN of the e-mode gates 19 will act to deplete the 2DEG concentration under the d-mode gate 21 to reduce the pinch off voltage.

In FIG. 5, the structure 10c includes pGaN islands (e-mode gates 19) inside holes or openings 21a of the d-mode gate 21. In this way, the d-mode gate 21 surrounds the e-mode gate 19. This configuration will reduce high fields at the edges of the pGaN, e.g., of e-mode gate 19. In alternative embodiments, the e-mode gate 19 may surround the d-mode gate 21 in a similar manner.

FIG. 6A shows a top view of device with isolation regions and FIG. 6B is a cross-sectional view of the device of FIG. 6A along lines A-A. In FIGS. 6A and 6B, the structure 10d includes the d-mode gate 21 and the e-mode gate 19 surrounded by isolation regions 27. In embodiments, the isolation regions 27 may be formed in the semiconductor material 14 by an implantation process using, e.g., argon or nitrogen implants. In embodiments, other noble or inert gases may be used to form the isolation regions 27. In further embodiments, the gate metal may be used to mask the device for the implant process. The isolation regions 27 may be self-aligned with the e-mode gate 19 and d-mode gate21, used to modulate and improve pinch off voltage. In further embodiments, the isolation regions 27 may also surround (isolate) the field plates 22, 22a.

In FIGS. 7A and 7B, the structure 10e shows the field plate 22a of the d-mode gate (e.g., MIS capacitor) overlapping with the e-mode gates 19.

FIGS. 8A-8D show fabrication processes for manufacturing the structure shown in FIG. 1 in accordance with aspects of the present disclosure. It should be understood by those of ordinary skill in the art that similar fabrication processes may be used to manufacture the structure shown in FIGS. 2-7B.

FIG. 8A shows a pGaN island (e.g., e-mode gate 19) formed on the semiconductor material 14 (e.g., conducting channel). In embodiments, the semiconductor material 14 may be deposited on the semiconductor substrate 12 using any conventional deposition method, e.g., CVD. To form the e-mode gate 19, semiconductor material 16 may be epitaxially grown on the semiconductor material 14. In embodiments, an in-situ doping (e.g., p-type dopant) may be used during the epitaxial growth process. Conductive material 18, e.g., TiN, may be deposited on the semiconductor material 16. The semiconductor material 16 and conductive material 18 undergo conventional lithography and etching processes to form the e-mode gate 19, e.g., GaN island. In embodiments, the conductive material 18 may undergo an additional selective pull-back etching process to form the e-mode gate 19.

In FIG. 8B, a plurality of different materials 20 may be formed over the e-mode gate 19 and the semiconductor material 14. In embodiments, the plurality of different materials 20 may comprise, in sequential order, a conductive layer 20a, e.g., Al₂O₃, an etch stop layer 20b, e.g., SiN, and an insulator material 20c, e.g., SiO₂. The plurality of different materials 20a, 20b, 20c may be deposited by conventional deposition methods, e.g., CVD processes, in sequential order.

A trench 52 may be formed in the etch stop layer 20b and insulator material 20c, exposing the underlying conductive layer 20a. The trench 52 may be formed by conventional lithography and etching processes, with a selective chemistry to remove the etch stop layer 20b and insulator material 20c. In an optional embodiment, corners of the trench 52 may be tapered or rounded using conventional etching processes which are known in the art such that no further explanation is required for a complete understanding of the present disclosure.

In FIG. 8C, the field plates 22, 22a may be formed in contact with the conductive layer 20a, e.g., Al₂O₃, and the insulator material 20c, e.g., SiO₂. In more specific embodiments, conductive material may be blanket deposited within the trenches 52 and insulator material 20c. The conductive material may be, e.g., TiN, deposited by a conventional deposition process, e.g., CVD. Following the deposition process, the conductive material may undergo a conventional etching process to form the field plates 22, 22a in contact with the underlying conductive layer 20a and over the insulator material 20c. Additional insulator material 24a, e.g., interlevel dielectric material, may be formed over the field plates 22, 22a, which also fills in a remaining portion of the trench, as needed.

As further shown in FIG. 8D, additional interlevel dielectric material 24 may be deposited over the field plates 22, 22a. The gate contact metal 26, e.g., TiAl or TiN, may be formed in contact with the field plates 22, 22a and the conductive material 18, e.g., TiN, of the e-mode gate 19 using one or more conventional lithography, etching and deposition processes.

By way of example, a resist formed over the interlevel dielectric material 24 is exposed to energy (light) to form a pattern (opening). An etching process with a selective chemistry, e.g., RIE, will be used to transfer the pattern from the photoresist layer to the interlevel dielectric material 24 to form one or more trenches in the interlevel dielectric material 24. Following the resist removal by a conventional oxygen ashing process or other known stripants, conductive material can be deposited by any conventional deposition processes, e.g., chemical vapor deposition (CVD) processes. Any residual material on the surface of the interlevel dielectric material 24 can be removed by conventional chemical mechanical polishing (CMP) processes.

It should be understood by those of ordinary skill in the art that the gate contact metal 26 may be formed in several damascene processes, depending on the complexity of the shape of the gate contact metal 26. The ohmic contacts 28a-28f may also be formed in similar lithography, etching and deposition processes such that no further explanation is required herein for a complete understanding of the present disclosure.

Referring back to FIG. 1, the interlevel dielectric material 30 may be formed over the interlevel dielectric material 24 using conventional deposition processes, e.g., CVD. The back end of the line contacts (e.g., metal vias) 32 and metal wiring 34, 36 may be formed by one or more conventional lithography, etching and deposition processes as already described herein.

The HEMTs can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multichip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
at least one depletion mode gate on a conductive material over a semiconductor material; and
at least one enhancement mode gate electrically connected to the at least one depletion mode gate and over the semiconductor material.

2. The structure of claim 1, wherein the at least one enhancement mode gate comprises a GaN island with a gate metal connecting to the GaN island.

3. The structure of claim 2, further comprising an intervening conductive material between the GaN island and the gate metal connecting to the GaN island.

4. The structure of claim 2 or claim 3, wherein the GaN island is a p-doped GaN island.

5. The structure of claim 1, wherein the at least one depletion mode gate comprises a field plate, and, optionally, wherein the at least one depletion mode gate comprises a metal insulator semiconductor (MIS) capacitor.

6. The structure of claim 5, wherein the semiconductor material comprises a common conducting channel of the at least one depletion mode gate and the least one enhancement mode gate, and the field plate of the at least one depletion mode gate forms part of the MIS capacitor, and, optionally, wherein the common conducting channel comprises GaN.

7. The structure of one of claims 1 to 6, wherein the at least one depletion mode gate and the least one enhancement mode gate comprise alternating islands of pGaN and MIS gate structures under a single gate metal finger.

8. The structure of one of claims 1 to 6, wherein the at least one depletion mode gate surrounds the at least one enhancement mode gate.

9. The structure of one of claims 1 to 8, further comprising isolation regions in the semiconductor material, the isolation regions surrounding the least one enhancement mode gate and the at least one depletion mode gate, and, optionally, wherein the isolation regions surround field plates of the at least one depletion mode gate.

10. The structure of one of claims 1 to 9, wherein a field plate comprising the at least one depletion mode gate overlaps with the at least one enhancement mode gate.

11. A structure comprising:
a metal-insulator-semiconductor (MIS) capacitor, the MIS capacitor comprising a metal plate over a common conducting channel; and
an island of semiconductor material over a semiconductor substrate and electrically connected to the MIS capacitor.

12. The structure of claim 11, wherein the common conducting channel comprises GaN.

13. The structure of claim 11 or claim 12, further comprising isolation regions surrounding the MIS capacitor and the island of semiconductor material, and, optionally, wherein the island of semiconductor material comprises pGaN.

14. The structure of one of claims 11 to 13, wherein the metal plate of the MIS capacitor overlaps with the island of semiconductor material and/or wherein the island of semiconductor material comprises an enhancement mode gate.

15. A method comprising:
forming at least one depletion mode gate comprising a field plate on a conductive material over a semiconductor material; and
forming at least one enhancement mode gate electrically connected to the at least one depletion mode gate and over the semiconductor material.
